# EUROPÄISCHE PATENTANMELDUNG

(11) **EP 2 139 117 A1**
(43) Veröffentlichungstag der Anmeldung: **30.12.2009**
(21) Anmeldenummer: 09007378.4
(22) Anmeldetag: 04.06.2009
(51) Int. Cl.: H03K 17/18

(54) **Verfahren und elektronische Schaltung für eine elektronische Schaltungseinheit**

(30) Priorität: 23.06.2008 DE 102008029680
(71) Anmelder: Moeller GmbH, 53115 Bonn (DE)
(72) Erfinder: Culca, Horea-Stefan, 53797 Lohmar (DE)

(57) **Zusammenfassung**

Die vorliegende Erfindung betrifft ein Verfahren und eine elektronische Schaltung für elektronische Schaltungseinheit (110), welche zum Betrieb mindestens einer elektrischen Last (130) über mindestens einen Ausgang (115,116) eingerichtet ist, umfassend: Schalten von jeweils einem Ausgang des mindestens einen Ausgangs (115,116) in einen ersten oder einen zweiten Zustand in Abhängigkeit eines an einem von mindestens einem Eingang (111,112) der elektronischen Schaltungseinheit (110) anliegenden Eingangssignals, wobei dieser Ausgang im ersten Zustand eine angeschlossene Last (130) abschaltet und im zweiten Zustand die angeschlossene elektrische Last (130) betreibt, und Einschalten bzw. Ausschalten einer zwischen dem mindestens einem Ausgang (115,116) und einem Massepotential (105,850) angeordneten Entladeschaltung (120,120',120",830).

## Beschreibung

Die vorliegende Erfindung betrifft ein Verfahren und eine elektronische Schaltung für eine elektronische Schaltungseinheit, welche zum Betrieb mindestens einer elektrischen Last über mindestens einen Ausgang der elektronischen Schaltungseinheit eingerichtet ist.

### STAND DER TECHNIK

Elektronische Schaltungseinheiten werden in einer Vielzahl von Bereichen eingesetzt, wie z.B. zum Ansteuern, Regeln, Schalten oder ähnlichem von elektrischen Lasten.

Die elektronische Schaltungseinheit kann beispielsweise ein Treiberelement mit einem Ausgang zur Ansteuerung einer elektrischen Last darstellen. Die elektrische Last kann beispielsweise eine Steuereinheit für einen Elektromotor sein oder ein anderes elektrisches Gerät darstellen. Der Ausgang der elektronischen Schaltungseinheit ist zum Abschalten der elektrischen Last in einen ersten Zustand schaltbar und zum Betreiben der elektrischen Last in einen zweiten Zustand schaltbar.

Während des Betriebs der elektrischen Last ist es oftmals erforderlich, die Zuverlässigkeit des Ausgangs der elektronischen Schaltungseinheit zu überprüfen, d.h. zu überprüfen, ob der Ausgang in Abhängigkeit eines Eingangssignals korrekt in den ersten bzw. den zweiten Zustand geschaltet wird. Insbesondere muss sichergestellt werden, dass der Ausgang der elektronischen Schaltungseinheit korrekt in den ersten Zustand schaltet, wenn dies vom Eingangssignal vorgegeben wird, so dass die elektrische Last zuverlässig abgeschaltet werden kann.

Hierzu kann im normalen Betrieb der elektrischen Last, d.h. wenn der Ausgang in den zweiten Zustand geschaltet ist, das entsprechende Eingangssignal kurzzeitig durch ein Testsignal so angesteuert werden, so dass der Ausgang in den ersten Zustand angesteuert wird, und es kann durch Auslesen des Ausgangs überprüft werden, ob die Ausgangsspannung entsprechend dem ersten Zustand gegen Null abfällt.

Die elektrische Last kann jedoch eine kapazitive Last darstellen, wie es z.B. bei einer Steuereinheit eines Elektromotors der Fall sein kann, so dass die vorher hohe Betriebsspannung an dem Ausgang nach dem Schalten vom zweiten Zustand in den ersten Zustand nur langsam abfällt, falls der Ausgang mit einem "High-Side" Treiber realisiert wird, wie es z.B. bei industriellen Steuerungen der Fall ist (siehe beispielsweise SPS-Norm EN61131-2). Somit müsste der zu überprüfende Ausgang für eine längere Zeit in den ersten Zustand geschaltet werden, da vorher keine zuverlässige Aussage über den eigentlichen Zustand an diesem Ausgang gemacht werden kann. Diese längere Abschaltzeitspanne weist allerdings den Nachteil auf, dass der Betrieb der elektrischen Last beeinträchtigt werden kann.

### BESCHREIBUNG DER ERFINDUNG

Der Erfindung liegt davon ausgehend die Aufgabe zugrunde, das Schaltverhalten des Ausgangs der oben beschriebenen Art einer elektrischen Schalteinheit zu verbessern.

Diese Aufgabe wird gelöst durch eine elektronische Schaltung, umfassend eine mindestens einen Eingang und mindestens einen Ausgang aufweisende elektronische Schaltungseinheit zum Betreiben mindestens einer elektrischen Last, wobei die Schaltungseinheit dazu eingerichtet ist, jeweils einen Ausgang des mindestens einen Ausgangs in Abhängigkeit eines an einem des mindestens einen Eingangs anliegenden Eingangsignals in einen ersten oder einen zweiten Zustand zu schalten, wobei dieser Ausgang im ersten Zustand eine angeschlossene elektrische Last abschaltet und im zweiten Zustand die angeschlossene elektrische Last betreibt, und wobei die elektronische Schaltung eine zwischen dem mindestens einen Ausgang und einem Massepotential angeordnete ein- und ausschaltbare Entladeschaltung umfasst.

Diese Aufgabe wird ferner gelöst durch ein Verfahren zum Betreiben mindestens einer elektrischen Last über mindestens einen Ausgang einer elektronischen Schaltungseinheit, umfassen: Schalten von jeweils einem Ausgang des mindestens einen Ausgangs in einen ersten oder einen zweiten Zustand in Abhängigkeit eines an einem des mindestens einen Eingang anliegenden Eingangssignals, wobei dieser Ausgang im ersten Zustand eine angeschlossene Last abschaltet und im zweiten Zustand die elektrische Last betreibt, und Einschalten bzw. Ausschalten einer zwischen dem mindestens einem Ausgang und einem Massepotential angeordneten Entladeschaltung.

Beispielsweise wird einer des mindestens einen Ausgangs im ersten Zustand auf einen sehr geringen Spannungspegel oder auf Masse gelegt, so dass eine mit diesem Ausgang verbundene elektrische Last nicht angetrieben wird, und im zweiten Zustand auf einen hohen Spannungspegel zum Betreiben der elektrischen Last gesetzt. Der hohe Spannungspegel kann von der jeweiligen zu betreibenden elektrischen Last abhängen. Somit kann jeweils eine von mindestens einer elektrischen Last über ein entsprechendes Eingangssignal an einem des mindestens einen Eingangs gezielt angesteuert werden. Die elektronische Schaltungseinheit kann beispielsweise eine Treiberschaltung mit Halbleiterausgängen darstellen, wobei die Treiberschaltung durch mindestens einen High-Side Treiber realisiert ist.

Die elektrische Last kann beispielsweise eine Steuereinheit für einen Elektromotor sein oder ein anderes elektrisches Gerät darstellen.

Des Weiteren umfasst die elektronische Schaltung eine zwischen dem mindestens einen Ausgang und einem Massepotential angeordnete Entladeschaltung. Das Massepotential stellt ein gegenüber einer positiven Versorgungsleitung tieferliegendes Potential dar.

Die Entladeschaltung ist ein- und ausschaltbar, z.B. über mindestens einen Steuereingang, wobei die Entladeschaltung im eingeschalteten Zustand mindestens einen des mindestens einen Ausgangs mit dem Massepotential verbindet, und im ausgeschalteten Zustand keinen des mindestens einen Ausgangs mit dem Massepotential verbindet.

Die ein- und ausschaltbare Entladeschaltung ermöglicht es beispielsweise, dass die mindestens eine elektrische Last durch Ansteuern des mindestens einen Ausgangs in den zweiten Zustand betrieben wird, wobei während des zweiten Zustands die Entladeschaltung abgeschaltet werden kann und somit keinen Einfluss auf den mindestens einen Ausgang ausübt.

Hierbei ist gleichzeitig die Entladeschaltung geschützt. Tritt z.B. zwischen dem Ausgang und einem Versorgungsspannungsanschluss ein Kurzschluss auf und wäre gleichzeitig die Entladeschaltung eingeschaltet, so würde der Kurzschlussstrom über eine eingeschaltete Entladeschaltung abfließen und diese stark belasten und eventuell sogar zerstören. Ist die Entladeschaltung abgeschaltet, so kann dies vermieden werden und ein Schutz der Entladeschaltung erreicht werden.

Soll beispielsweise während des Betriebs einer elektrischen Last ein Ausgang vom zweiten in den ersten Zustand geschaltet werden, z.B. zum Ausschalten der Last oder für Testzwecke, so kann der dieser elektrischen Last zugeordnete Ausgang in den ersten Zustand angesteuert werden und gleichzeitig oder kurz zeitversetzt die Entladeschaltung eingeschaltet werden. Durch das Einschalten der Entladeschaltung wird der zugeordnete Ausgang über die Entladeschaltung mit dem Massepotential, welches auch ein tieferliegendes Potential darstellen kann, verbunden, so dass eine zügige Entladung des zugeordneten Ausgangs erfolgen kann und es somit ermöglich wird, dass der Spannungspegel an diesem Ausgang schnell auf einen sehr kleinen Pegel gemäß dem ersten Zustand abfällt, auch wenn die elektrische Last beispielsweise eine kapazitive Last darstellt.

Die Entladeschaltung kann eine elektronische Schaltung jeglicher Art sein, welche im eingeschalteten Zustand eine kontrollierte Entladung gegen das Massepotential ermöglicht. Die Entladeschaltung kann hierzu mindestens einen Widerstand und/oder auch weitere passive bzw. aktive elektronische Bauelemente umfassen, die Entladeschaltung kann auch beispielsweise auch einen Entladetransistor ohne weiteren Widerstand darstellen.

Somit kann der mindestens eine Ausgang der elektronischen Schaltungseinheit innerhalb kurzer Zeit vom zweiten Zustand in den ersten Zustand geschaltet werden, wenn hierbei die Entladeschaltung eingeschaltet wird. Ferner kann die Entladeschaltung abgeschaltet werden, so dass diese gegen externe Kurzschlüsse geschützt ist und auch keine Beeinträchtigung während des Betriebs der mindestens einen elektrischen Last während des zweiten Zustandes darstellt.

Eine Ausgestaltung der Erfindung sieht vor, dass die Entladeschaltung jeweils eine Schalteinheit und eine Entladeeinheit für jeweils einen des mindestens einen Ausgangs umfasst, und die Schalteinheit dazu eingerichtet ist, in einem eingeschalteten Zustand den jeweiligen Ausgang über die Entladeeinheit mit dem Massepotential zu verbinden und in einem ausgeschalteten Zustand vom Massepotential zu trennen.

Somit kann beispielsweise jeder einzelne des mindestens einen Ausgangs über die ihm zugeordnete Entladeeinheit und die ihm zugeordnete Schalteinheit unabhängig von den anderen Ausgängen der elektronischen Schaltungseinheit mit dem Massepotential verbunden werden bzw. hiervon getrennt werden. Die Schalteinheit kann beispielsweise eine elektromechanische Schalteinheit, wie z.B. ein Relais, darstellen, oder auch einen halbleiterbasierten Schalter darstellen, wie z.B. ein Transistor.

Die Entladeeinheit kann beispielsweise ein Widerstand sein.

Eine Ausgestaltung der Erfindung sieht vor, dass die elektronische Schaltung eine Steuereinheit umfasst, welche mit mindestens einem des mindestens einen Eingangs der elektronischen Schaltungseinheit und mit der Entladeschaltung verbunden ist und dazu eingerichtet ist, in Abhängigkeit eines für die Ansteuerung eines Ausgangs des mindestens einen Ausgangs angelegten Eingangssignals die diesem Ausgang zugeordnete Schalteinheit der Entladeschaltung in den eingeschalteten Zustand anzusteuern, wenn das Eingangssignal den jeweiligen Ausgang in den ersten Zustand ansteuert.

Somit ermöglicht es die Steuereinheit, dass automatisch beim Ansteuern eines des mindestens einen Ausgangs in den ersten Zustand durch ein entsprechendes Eingangssignal an einem der Eingänge die diesem Ausgang zugeordnete Schalteinheit der Entladeschaltung in den eingeschalteten Zustand angesteuert werden kann und die Entladung für diesen Ausgang ausgeführt werden kann. Wird dieser Ausgang nicht in den ersten Zustand angesteuert, so kann die zugeordnete Schalteinheit von der Steuereinheit beispielsweise in den abgeschalteten Zustand angesteuert werden, so dass keine Beeinflussung dieses Ausgangs durch die Entladeschaltung erfolgt und gleichzeitig die diesem Ausgang zugeordnete Entladeeinheit geschützt ist.

Die Steuereinheit kann beispielsweise ein Mikrocontroller sein, welcher die elektronische Schaltungseinheit und somit die an die Ausgänge angeschlossenen elektrischen Lasten ansteuert.

Die Steuereinheit kann aber auch derart ausgestaltet sein, dass nicht die Eingänge der elektronischen Schaltungseinheit angesteuert werden, sondern dass mindestens ein Eingangssignal des mindestens einen Eingangs der elektronischen Schaltungseinheit von der Steuereinheit ausgelesen wird und dementsprechend die zugeordnete Schalteinheit der Entladeeschaltung angesteuert wird.

Eine Ausgestaltung der Erfindung sieht vor, dass die Steuereinheit einen ersten Eingang und einen zweiten Eingang umfasst, wobei der erste Eingang mit dem mindestens einem Eingang der elektronischen Schaltungseinheit verbunden ist, und wobei die Steuereinheit dazu eingerichtet ist, eine Notabschaltung der ein- und ausschaltbaren Entladeschaltung in Reaktion auf ein an den zweiten Eingang angelegtes Ausschaltsignal durchzuführen.

Somit kann beispielsweise im Normalbetrieb über den ersten Eingang detektiert werden, ob ein Eingangssignal der elektronischen Schaltungseinheit den jeweiligen Ausgang in den ersten Zustand ansteuert, so dass die diesem Ausgang zugeordnete Schalteinheit der Entladeschaltung von der Steuereinheit in den eingeschalteten Zustand angesteuert werden kann, wie zuvor erläutert. Wird jedoch an den zweiten Eingang der Steuereinheit ein Ausschaltsignal angelegt, so führt die Steuereinheit eine Notabschaltung der Entladeschaltung durch, d.h. die mindestens eine Schalteinheit wird dauerhaft in den ausgeschalteten Zustand angesteuert. Wird diese Notabschaltung über den zweiten Eingang ausgelöst, so hat der erste Eingang keinen Einfluss mehr auf die Steuerung der Entladeschaltung. Beispielsweise kann somit bei einem detektierten Fehlerfall eine Notabschaltung über den zweiten Eingang der Steuereinheit durchgeführt werden.

Eine Ausgestaltung der Erfindung sieht vor, dass die elektronische Schaltung dazu eingerichtet ist, die Entladeschaltung durch ein Ausschaltsignal dauerhaft in den ausgeschalteten Zustand zu schalten.

Wird dieses Ausschaltsignal gesetzt, so kann die Entladeschaltung nicht mehr in den eingeschalteten Zustand geschaltet werden. Somit kann die Entladeschaltung in einen sicheren Modus versetzt werden, in dem die Entladeeinheiten geschützt sind.

Beispielsweise kann dieses Ausschaltsignal an den zweiten Eingang der Steuereinheit angelegt werden und somit die Notabschaltung bewirken.

So können die Entladeeinheiten beispielsweise Widerstände darstellen, welche von der Leistung her für kurze Impulse dimensioniert sind. Sollte im ausgeschalteten Zustand extern ein Kurzschluss entstehen, so wären die betroffenen Widerstände stark überlastet. Somit kann beispielsweise die Entladeschaltung zum Schutz der Widerstände mit dem Ausschaltsignal in den sicheren Modus versetzt werden, wenn die elektronische Schaltungseinheit abgeschaltet wird.

Eine Ausgestaltung der Erfindung sieht vor, dass die elektronische Schaltung eine ein- und ausschaltbare Stromversorgungseinheit für die elektronische Schaltungseinheit und eine Detektionseinheit umfasst, wobei die Detektionseinheit dazu eingerichtet ist, einen ausgeschalteten Zustand der Stromversorgungseinheit zu detektieren und auf Grundlage des detektierten ausgeschalteten Zustandes das Ausschaltsignal zum dauerhaften Ausschalten der Entladeschaltung auszugeben.

Die Detektionseinheit kann hierzu mit dem zweiten Eingang der Steuereinheit verbunden sei, so dass das Ausschaltsignal an den zweiten Eingang der Steuereinheit zur Notabschaltung angelegt werden kann.

Die Stromversorgungseinheit kann beispielsweise ein Schaltelement umfassen, welches beispielsweise mit einer stromzuführenden Leitung und mit einer hin zur elektrischen Schaltungseinheit stromabführenden Leitung verbunden ist. Über einen ersten Eingang kann das Schaltelement ein- bzw. ausgeschaltet werden, so dass die Stromzufuhr zur elektronischen Schaltungseinheit ein- bzw. ausgeschaltet werden kann.

Auf Grundlage des detektierten ausgeschalteten Zustandes kann die Detektionseinheit das Ausschaltsignal zum dauerhaften Ausschalten der Entladeschaltung ausgeben. Die Detektionseinheit kann beispielsweise physikalisch erfassen, ob an der stromabführenden Leitung die Versorgungsspannung anliegt, oder sie kann anderweitig detektieren, ob sich die Stromversorgungseinheit im eingeschalteten bzw. ausgeschalteten Zustand befindet, z.B. auf Grundlage eines an einem Schalteingang anliegenden Schaltsignals.

Das Ausschaltsignal kann beispielsweise die Steuereinheit zum dauerhaften Abschalten der Entladeschaltung ansteuern, aber das Ausschaltsignal kann auch der Entladeschaltung direkt zugeführt werden.

Somit kann ein Abschalten der Stromversorgung detektiert werden und automatisch die Entladeschaltung über das am Ausgang ausgegebene Ausschaltsignal in den sicheren, d.h. abgeschalteten Zustand geschaltet werden. Hierdurch kann beispielsweise ein separater Signaleingang zum dauerhaften Ausschalten der Entladeschaltung gespart werden, da das Setzen des Ausschaltsignals der Entladeschaltung durch Detektion des abgeschalteten Zustands der Stromversorgungseinheit erfolgen kann. Hierdurch kann z.B. ein sonst notwendiger Kontakt bei einer Steckverbindung zu einem Mikrocontroller gespart werden.

Eine Ausgestaltung der Erfindung sieht vor, dass die Detektionseinheit eine Zeitverzögerungseinheit umfasst, so dass das Ausschaltsignal nach Detektion des ausgeschalteten Zustandes der Stromversorgung mit einer Zeitverzögerung ausgegeben wird.

Somit wird die Entladeschaltung nicht unmittelbar nach Abschalten der Stromversorgung in den sicheren Zustand geschaltet. Dies kann beispielsweise dann hilfreich sein, wenn die elektronische Schaltungseinheit für Testzwecke kurzzeitig abgeschaltet wird und der Zustand der Ausgänge nach dem Abschalten kontrolliert werden soll. Somit bleibt die Entladefunktion der Entladeschaltung auch nach Abschalten der Stromversorgung für die vorgegebene Zeitverzögerung erhalten.

Eine Ausgestaltung der Erfindung sieht vor, dass die ein- und ausschaltbare Stromversorgungseinheit einen ersten Steuereingang und einen zweiten Steuereingang zum Abschalten der Stromversorgungseinheit aufweist, wobei die Stromversorgungseinheit dazu eingerichtet ist, über den zweiten Steuereingang unabhängig vom ersten Steuereingang abgeschaltet zu werden, und wobei die elektronische Schaltung eine weitere Steuereinheit umfasst, welche mit dem ersten und zweiten Steuereingang und mit mindestens einem Ausgang der elektronischen Schaltungseinheit verbunden ist, und wobei die weitere Steuereinheit dazu eingerichtet ist, während des Betriebs einer elektrischen Last den ersten Steuereingang zum Abschalten der Stromversorgungseinheit für eine kurze Zeit anzusteuern und den Zustand mindestens eines Ausgangs der elektronischen Schaltungseinheit auszulesen.

So kann z.B. die elektronische Schaltung eine Testfunktion zum Testen des Abschaltens der Stromversorgungseinheit aufweisen, wobei während des Betriebs einer elektrischen Last den ersten Steuereingang zum Abschalten der Stromversorgungseinheit für eine kurze Zeit angesteuert wird und der Zustand mindestens einen Ausgangs der elektronischen Schaltungseinheit ausgelesen wird. Entspricht der Zustand eines des mindestens einen ausgelesen Ausgangs nicht dem ersten Zustand, dann kann die Stromversorgungseinheit über den zweiten Steuereingang, der als zweiter Abschaltweg betrachtet werden kann, komplett abgeschaltet werden. Somit kann während des Betriebs die Abschaltfunktion über den ersten Abschalteingang und dem Schaltelement überwacht werden.

Eine Ausgestaltung der Erfindung sieht vor, die Stromversorgungseinheit über den zweiten Steuereingang abzuschalten, wenn der ausgelesene Zustand einer des mindestens einen ausgelesenen Ausgangs nicht dem ersten Zustand entspricht.

Die Schalteinheit kann auch anderweitig abgeschaltet werden.

Eine Ausgestaltung der Erfindung sieht vor, dass die elektronische Schaltung eine weitere Steuereinheit umfasst, welche mit dem mindestens einem Eingang und dem mindestens einem Ausgang der elektronischen Schaltungseinheit verbunden ist und dazu eingerichtet ist, ein Eingangssignal zur Ansteuerung jeweils eines Ausgangs des mindestens einen Ausgangs an mindestens einen des mindestens einen Eingangs anzulegen, wobei die weitere Steuereinheit das Eingangssignal des jeweiligen Ausgangs zum Betreiben einer angeschlossenen elektrischen Last in den zweiten Zustand ansteuert und während des Betriebs dieser elektrischen Last den jeweiligen Ausgang für eine kurze Zeit in den ersten Zustand ansteuert, wobei die Steuereinheit während dieser kurzen Zeit den Zustand des jeweiligen Ausgangs ausliest.

Soll beispielsweise die Zuverlässigkeit der Ausgänge der elektronischen Schaltungseinheit überprüft werden, so kann mit einem entsprechenden Eingangssignal am jeweiligen Eingang des mindestens einen Eingangs der zugeordnete Ausgang kurzzeitig in den ersten Zustand versetzt werden und z.B. gleichzeitig die Entladeschaltung eingeschaltet werden. Durch das Einschalten der Entladeschaltung wird der zugeordnete Ausgang über die Entladeschaltung mit dem Massepotential, welches auch ein tieferliegendes Potential darstellen kann, verbunden.

Somit kann beispielsweise direkt bzw. kurz nach dem Schalten in den ersten Zustand und Einschalten der Entladeschaltung an dem zugeordneten Ausgang durch Auslesen des Spannungspegels an diesem Ausgang von der weiteren Steuereinheit durch Auslesen des Zustands des Ausgangs überprüft werden, ob dieser Ausgang ordnungemäß in den ersten Zustand geschaltet wurde, d.h. ob beispielsweise der Spannungspegel gemäß dem angesteuerten ersten Zustand ordnungsgemäß auf einen sehr niedrigen Spannungspegel oder auf Null abgefallen ist. Die eingeschaltete Entladeschaltung sorgt dafür, wenn die elektrische Last eine kapazitive Last darstellt, dass die kapazitive Last schnell entladen wird, vorausgesetzt, der Ausgang wurde ordnungsgemäß abgeschaltet. Somit wird vermieden, dass die Spannung an diesem Ausgang trotz ordnungsgemäßem Abschalten aufgrund einer kapazitiven Last nur langsam von einem dem zweiten Zustand zugeordneten hohen Spannungspegel abfällt und so ein schnelles Überprüfen des korrekten Abschaltens an diesem Ausgang verhindert wird.

Folglich reicht durch die Verwendung der einschaltbaren Entladeschaltung eine kurze Zeitdauer aus, in der der zu testende Ausgang vom zweiten Zustand in den ersten Zustand angesteuert wird, so dass der Betrieb der jeweiligen elektrischen Last durch diese kurze Testphasen nicht oder nur minimal beeinträchtigt wird.

Tritt während dieser Testphase beim kurzzeitigen Ansteuern einer der Ausgänge in den ersten Zustand ein Fehler der elektronischen Schaltungseinheit auf, d.h. entspricht der ausgelesene Zustand des zu testenden Ausgangs nicht dem erwarteten ersten Zustand, d.h. bleibt der Spannungspegel an dem jeweiligen Ausgang auf einem entsprechend dem zweiten Zustand hohen Niveau, so fließt zwar ein recht hoher Strom durch die eingeschaltete Entladeschaltung, da diese Zeitdauer jedoch sehr kurz gewählt werden kann, z.B. nur eine Millisekunde oder nur wenige Millisekunden, oder ein anderer kurzer Wert, ist dieser hohe Strom für die Entladeschaltung unschädlich. Wird an einem Ausgang ein Fehler festgestellt, so kann die elektronische Schaltungseinheit beispielsweise über einen gesonderten Abschaltweg in einen sicheren Zustand gebracht werden, in dem die Ausgänge abgeschaltet werden.

Somit kann mit der vorliegenden Erfindung auch bei elektrischen Lasten, welche kapazitive Lasten darstellen, durch gezieltes Zuschalten der ein- und ausschaltbaren Entladeeinheit und Ansteuern eines Ausgangs der elektrischen Schaltungseinheit in den ersten Zustand das sichere Abschalten des entsprechenden Ausgang während des Betriebes schnell getestet werden.

Ist der zu testende Ausgang fehlerfrei getestet worden, d.h. entspricht der ausgelesene Zustand dem ersten Zustand, so wird die Entladeschaltung wieder abgeschaltet und der entprechende Ausgang wird zum weiteren Betrieb der elektrische Last wieder in den zweiten Zustand geschaltet. So kann während des Betriebs einer elektrischen Last der zugeordnete Ausgang durch kurzzeitiges Ansteuern in den ersten Zustand, Einschalten der Entladeschaltung und Auslesen des an diesem Ausgang anliegenden Zustands getestet werden. Dies kann z.B. in zyklischen Abständen durch Testimpulse erfolgen. Wird ein Fehler detektiert, so kann die elektronische Schaltungseinheit von der weiteren Steuereinheit durch ein Signal am Ausgang, welcher mit einem Schalteingang der Stromversorgungseinheit verbunden ist, abgeschaltet werden.

Eine Ausgestaltung der Erfindung sieht vor, dass die weitere Steuereinheit dazu eingerichtet ist, die elektronische Schaltungseinheit abzuschalten, wenn der ausgelesene Zustand eines Ausgangs während jener kurzen Zeit nicht dem ersten Zustand entspricht.

### KURZE BESCHREIBUNG DER FIGUREN

Die Erfindung wird im Folgenden anhand von Ausführungsbeispiele zeigenden Zeichnungen näher erläutert.

Dabei zeigen:
- Fig. 1:: Eine schematische Darstellung einer ersten beispielhaften Ausführungsform der vorliegenden Erfindung;
- Fig. 2:: Eine schematische Darstellung einer zweiten beispielhaften Ausführungsform der vorliegenden Erfindung;
- Fig. 3:: Eine schematische Darstellung einer dritten beispielhaften Ausführungsform der vorliegenden Erfindung;
- Fig. 4:: Eine schematische Darstellung einer vierten beispielhaften Ausführungsform der vorliegenden Erfindung;
- Fig. 5:: Eine schematische Darstellung einer fünften beispielhaften Ausführungsform der vorliegenden Erfindung;
- Fig. 6:: Eine schematische Darstellung einer beispielhaften Entladeschaltung der vorliegenden Erfindung;
- Fig. 7:: Eine schematische Darstellung einer beispielhaften Stromversorgungseinheit und Detektionseinheit für die vorliegende Erfindung;
- Fig. 8:: Eine schematische Darstellung einer sechsten beispielhaften Ausführungsform der vorliegenden Erfindung;
- Fig. 9a:: Eine schematische Darstellung eines Flussdiagramms eines beispielhaften Verfahrens der vorliegenden Erfindung; und
- Fig. 9b:: Eine schematische Darstellung eines Flussdiagramms eines weiteren beispielhaften Verfahrens der vorliegenden Erfindung.

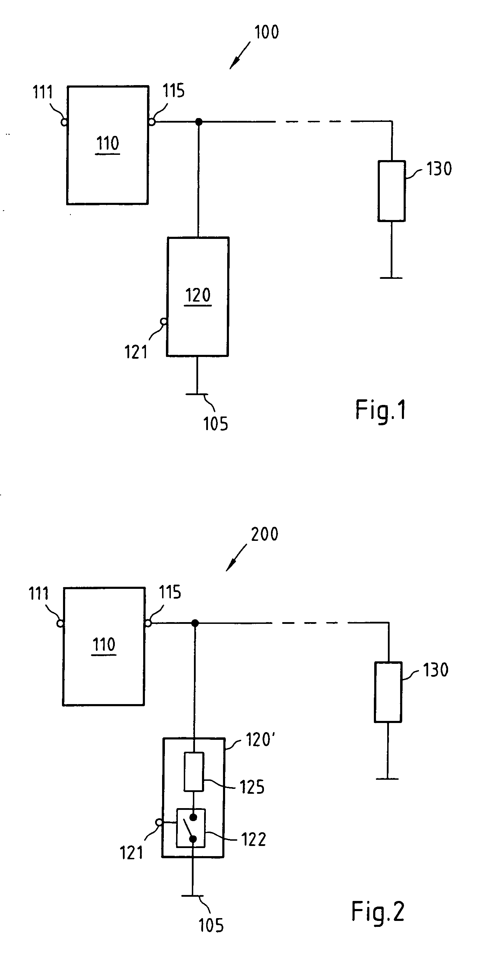

Fig. 1 zeigt eine schematische Darstellung einer ersten beispielhaften Ausführungsform einer elektronischen Schaltung 100 der vorliegenden Erfindung.

Die elektronische Schaltung 100 umfasst eine mindestens einen Eingang 111 und mindestens einen Ausgang 115 aufweisende elektronische Schaltungseinheit 110 zum Betreiben einer oder mehrerer elektrischer Lasten 130. Die elektronische Schaltungseinheit 110 ist dazu eingerichtet, jeweils einen Ausgang 115 des mindestens einen Ausgangs 115 in Abhängigkeit eines an einem des mindestens einen Eingangs 111 anliegenden Eingangssignals in einen ersten oder einen zweiten Zustand zu schalten, wobei dieser Ausgang 115 des mindestens einen Ausgangs 115 im ersten Zustand eine angeschlossene elektrische Last 130 abschaltet und im zweiten Zustand die elektrische Last 130 betreibt.

Beispielsweise wird der Ausgang 115 im ersten Zustand auf einen sehr geringen Spannungspegel oder auf Masse gelegt, so dass die elektrische Last 130 nicht angetrieben wird, und im zweiten Zustand auf einen hohen Spannungspegel zum Betreiben der elektrischen Last 130 gesetzt. Der hohe Spannungspegel kann von der jeweiligen zu betreibenden elektrischen Last 130 abhängen. Somit kann jeweils eine von mindestens einer elektrischen Last 130 über ein entsprechendes Eingangssignal an einem des mindestens einen Eingangs 111 gezielt angesteuert werden.

Die elektrische Last 130 kann beispielsweise eine Steuereinheit für einen Elektromotor sein oder ein anderes elektrisches Gerät darstellen.

Des Weiteren umfasst die elektronische Schaltung 110 eine zwischen dem mindestens einen Ausgang 115 und einem Massepotential 105 angeordnete Entladeschaltung 120. Die Entladeschaltung 120 ist ein- und ausschaltbar, z.B. über einen Steuereingang 121, wobei die Entladeschaltung 120 im eingeschalteten Zustand mindestens einen des mindestens einen Ausgangs 115 mit dem Massepotential 105 verbindet, und im ausgeschalteten Zustand keinen des mindestens einen Ausgangs 115 mit dem Massepotential 105 verbindet.

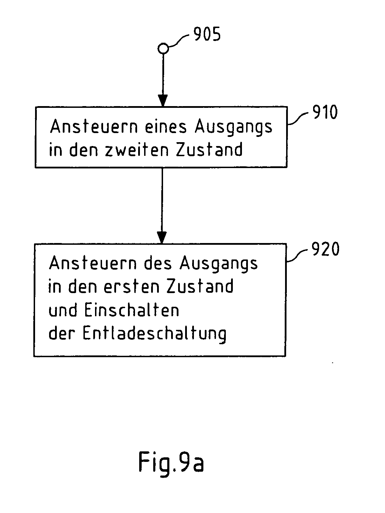

Eine mögliche Funktionsweise der elektronischen Schaltung 100 wird im Folgenden zusammen mit dem in Fig. 9a dargestellten Flussdiagrams eines beispielhaften Verfahrens der vorliegenden Erfindung erläutert.

Die ein- und ausschaltbare Entladeschaltung 120 ermöglicht es beispielsweise, die mindestens eine elektrische Last 130 durch Ansteuern des mindestens einen Ausgangs 115 in den zweiten Zustand zu betreiben (Schritt 910), wobei während des zweiten Zustands die Entladeschaltung 120 abgeschaltet werden kann und somit keinen Einfluss auf den mindestens einen Ausgang 115 ausübt. Hierbei ist gleichzeitig die Entladeschaltung 120 geschützt. Tritt z.B. zwischen dem Ausgang 115 und dem Versorgungsspannungsanschluss (nicht in Fig. 1 dargestellt) ein Kurzschluss auf und wäre gleichzeitig die Entladeschaltung eingeschaltet, so würde der Kurzschlussstrom über eine eingeschaltete Entladeschaltung 120 abfließen und diese stark belasten und eventuell sogar zerstören. Ist die Entladeschaltung 120 abgeschaltet, so kann dies vermieden werden und ein Schutz der Entladeschaltung 120 erreicht werden.

Soll beispielsweise während des Betriebs einer elektrischen Last 130 ein Ausgang vom zweiten in den ersten Zustand geschaltet werden, z.B. zum Ausschalten der Last oder für Testzwecke, so kann der dieser elektrischen Last 130 zugeordnete Ausgang in den ersten Zustand angesteuert werden und gleichzeitig bzw. kurz zeitversetzt die Entladeschaltung 120 eingeschaltet werden (Schritt 920). Durch das Einschalten der Entladeschaltung 120 wird der zugeordnete Ausgang 115 über die Entladeschaltung 120 mit dem Massepotential 105, welches auch ein tieferliegendes Potential darstellen kann, verbunden, so dass eine zügige Entladung des zugeordneten Ausgangs 115 erfolgen kann und es somit ermöglicht wird, dass der Spannungspegel an diesem Ausgang 115 schnell auf einen sehr kleinen Pegel gemäß dem ersten Zustand abfällt, auch wenn die elektrische Last 130 eine kapazitive Last darstellt.

Die Entladeschaltung 120 kann eine elektronische Schaltung jeglicher Art sein, welche im eingeschalteten Zustand eine kontrollierte Entladung gegen das Massepotential ermöglicht. Die Entladeschaltung 120 kann hierzu mindestens einen Widerstand und/oder auch weitere passive bzw. aktive elektronische Bauelemente umfassen.

Fig. 2 zeigt eine schematische Darstellung einer zweiten beispielhaften Ausführungsform der vorliegenden Erfindung.

Diese zweite beispielhafte Ausführungsform der elektronischen Schaltung 200 basiert auf der in Fig. 1 gezeigten und zuvor erläuterten ersten beispielhaften Ausführungsform, so dass die zuvor genannten Erläuterungen und Vorteile gleichermaßen für die zweite Ausführungsform gelten.

Die ein- und ausschaltbare Entladeschaltung 120' der elektronischen Schaltung 200 umfasst jeweils eine Schalteinheit 122 und eine Entladeeinheit 125 für jeweils einen der Ausgänge 115 der elektronischen Schaltungseinheit 110. Somit kann beispielsweise jeder einzelne der Ausgänge 115 über die ihm zugeordnete Entladeeinheit 125 und die ihm zugeordnete Schalteinheit 122 unabhängig von den anderen Ausgängen der elektronischen Schaltungseinheit 110 mit dem Massepotential 105 verbunden werden bzw. hiervon getrennt werden. Die Schalteinheit 122 kann beispielsweise eine elektromechanische Schalteinheit 105, wie z.B. ein Relais, darstellen, oder auch einen halbleiterbasierten Schalter darstellen, wie z.B. ein Transistor. Jede der Schalteinheiten lässt sich über einen Eingang 121 ein- und ausschalten. Die Entladeeinheit 125 kann beispielsweise ein Widerstand sein.

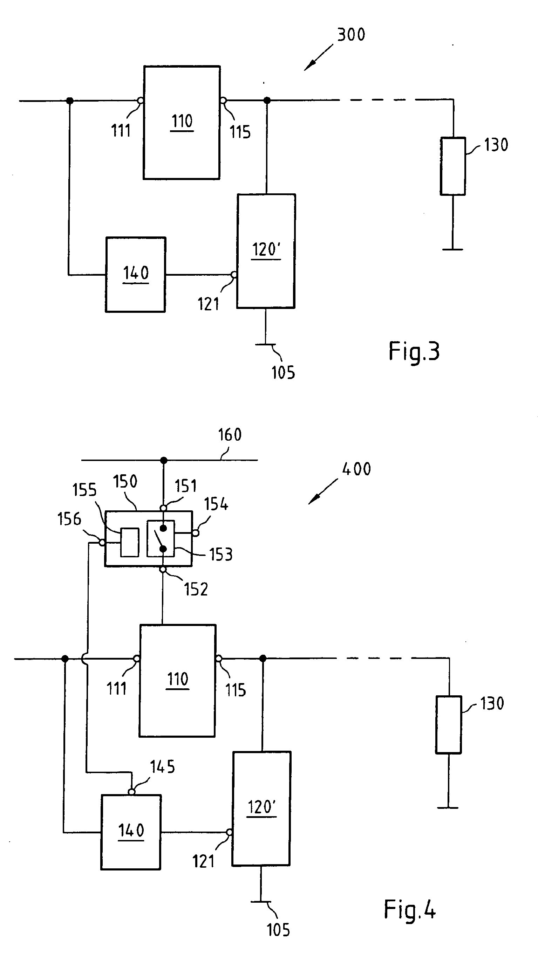

Fig. 3 zeigt eine schematische Darstellung einer dritten beispielhaften Ausführungsform der vorliegenden Erfindung.

Diese dritte beispielhafte Ausführungsform der elektronischen Schaltung 300 basiert auf der in Fig. 2 gezeigten und zuvor erläuterten zweiten beispielhaften Ausführungsform, so dass die zuvor genannten Erläuterungen und Vorteile gleichermaßen für die dritte Ausführungsform gelten.

Die elektronische Schaltung 300 in Fig. 3 umfasst eine Steuereinheit 140, welche mit mindestens einem des mindestens einen Eingangs 111 der elektronischen Schaltungseinheit 110 und mit dem Eingang 121 der Entladeschaltung 120' verbunden ist. Die Steuereinheit 140 ist dazu eingerichtet, in Abhängigkeit eines für die Ansteuerung eines Ausgangs des mindestens einen Ausgangs 115 angelegten Eingangssignals die diesem Ausgang 115 zugeordnete Schalteinheit 122 der Entladeschaltung 120' in den eingeschalteten Zustand anzusteuern, wenn das Eingangssignal den jeweiligen Ausgang in den ersten Zustand ansteuert.

Somit ermöglicht es die Steuereinheit 140, dass automatisch beim Ansteuern einer der Ausgänge 115 in den ersten Zustand durch ein entsprechendes Eingangssignal an einem der Eingänge 115 die diesem Ausgang zugeordnete Schalteinheit 122 in den eingeschalteten Zustand angesteuert wird und die Entladung für diesen Ausgang ausgeführt wird. Wird dieser Ausgang nicht in den ersten Zustand angesteuert, so kann die zugeordnete Schalteinheit 122 von der Steuereinheit 140 in den abgeschalteten Zustand angesteuert werden, so dass keine Beeinflussung des Ausgangs 115 durch die Entladeschaltung 120' erfolgt und gleichzeitig die diesem Ausgang zugeordnete Entladeeinheit 125 geschützt ist.

Die Steuereinheit 140 kann beispielsweise ein Mikrocontroller sein, welcher die elektronische Schaltungseinheit 110 und somit die an die Ausgänge 115 angeschlossenen elektrischen Lasten 130 ansteuert.

Die Steuereinheit 140 kann aber auch derart ausgestaltet sein, dass nicht die Eingänge 111 der elektronischen Schaltungseinheit 110 angesteuert werden, sondern dass mindestens ein Eingangssignal des mindestens einen Eingangs 111 von der Steuereinheit ausgelesen wird und dementsprechend die zugeordnete Schalteinheit 122 der Entladeeschaltung 120' angesteuert wird.

Fig. 4 zeigt eine schematische Darstellung einer vierten beispielhaften Ausführungsform der vorliegenden Erfindung.

Diese vierte beispielhafte Ausführungsform der elektronischen Schaltung 400 basiert auf der in Fig. 3 gezeigten und zuvor erläuterten dritten beispielhaften Ausführungsform, so dass die zuvor genannten Erläuterungen und Vorteile gleichermaßen für die vierte Ausführungsform gelten.

Die elektronische Schaltung 400 ist dazu eingerichtet, die Entladeschaltung 120' durch ein Ausschaltsignal dauerhaft in den ausgeschalteten Zustand zu schalten. Wird dieses Ausschaltsignal gesetzt, so kann die Entladeschaltung 120' nicht mehr in den eingeschalteten Zustand geschaltet werden. Somit kann die Entladeschaltung 120' in einen sicheren Modus versetzt werden, in dem die Entladeeinheiten 125 geschützt sind.

So können die Entladeeinheiten 125 beispielsweise Widerstände darstellen, welche von der Leistung her für kurze Impulse dimensioniert sind. Sollte im ausgeschalteten Zustand extern ein Kurzschluss entstehen, so wären die betroffenen Widerstände 125 stark überlastet. Somit kann beispielsweise die Entladeschaltung 120' zum Schutz der Widerstände 125 mit dem Ausschaltsignal in den sicheren Modus versetzt werden, wenn die elektronische Schaltungseinheit 110 abgeschaltet wird.

Die elektronische Schaltung 400 umfasst eine ein- und ausschaltbare Stromversorgungseinheit 150 für die elektronische Schaltungseinheit 110 und eine Detektionseinheit 155, welche dazu eingerichtet ist, einen ausgeschalteten Zustand der Stromversorgungseinheit zu detektieren. Die Stromversorgungseinheit 150 umfasst ein Schaltelement 153, welches beispielsweise über Anschluss 151 mit einer stromzuführenden Leitung 160 und über Anschluss 152 mit der elektronischen Schaltungseinheit 110 verbunden ist. Über den Eingang 154 kann das Schaltelement 153 ein- bzw. ausgeschaltet werden, so dass die Stromzufuhr zur elektronischen Schaltungseinheit 110 ein- bzw. ausgeschaltet werden kann.

Auf Grundlage des detektierten ausgeschalteten Zustandes kann die Detektionseinheit das Ausschaltsignal zum Ausschalten der Entladeschaltung 120' am Ausgang 156 ausgeben. Die Detektionseinheit 155 mit Ausgang 156 muss nicht zwingend in der Stromversorgungseinheit 150 platziert sein. Die Detektionseinheit 155 kann physikalisch erfassen, ob an Anschluss 152 die Versorgungsspannung anliegt, oder sie kann auf Grundlage eines an Schalteingang 154 anliegenden Schaltsignals detektieren, ob sich die Stromversorgungseinheit 150 im eingeschalteten bzw. ausgeschalteten Zustand befindet.

Das Ausschaltsignal kann beispielsweise die Steuereinheit 140 zum Abschalten der Entladeschaltung 120' ansteuern, wie in Fig. 4 dargestellt, aber das Ausschaltsignal kann auch der Entladeschaltung 120' direkt zugeführt werden.

Somit kann ein Abschalten der Stromversorgung detektiert werden und automatisch die Entladeschaltung über das an Ausgang 156 ausgegebene Ausschaltsignal in den sicheren, d.h. abgeschalteten Zustand geschaltet werden. Hierdurch kann beispielsweise ein separater Signaleingang zum dauerhaften Ausschalten der Entladeschaltung 120' gespart werden, da das Setzen des Ausschaltsignals der Entladeschaltung 120' durch Detektion des abgeschalteten Zustands der Stromversorgungseinheit 150 erfolgt.

Des Weiteren kann die Detektionseinheit 155 eine Zeitverzögerungseinheit umfassen (nicht in Fig. 4 dargestellt), welche dazu eingerichtet ist, das Ausschaltsignal nach erfolgter Detektion des ausgeschalteten Zustands der Stromversorgung mit einer vorgebbaren Zeitverzögerung auszugeben. Somit wird die Entladeschaltung 120' nicht unmittelbar nach Abschalten der Stromversorgung in den sicheren Zustand geschaltet. Dies kann dann notwendig sein, wenn die elektronische Schaltungseinheit 110 für Testzwecke kurzzeitig abgeschaltet wird und der Zustand der Ausgänge 115 nach dem Abschalten kontrolliert werden soll. Somit bleibt die Entladefunktion der Entladeschaltung 120' auch nach Abschalten der Stromversorgung für die vorgegebene Zeitverzögerung erhalten.

Die Stromversorgungseinheit kann beispielsweise neben dem Abschalteingang 154 einen zweiten Steuereingang 159 aufweisen, wobei die Stromversorgungseinheit 150 dazu eingerichtet ist, über den zweiten Steuereingang unabhängig vom ersten Steuereingang abgeschaltet zu werden. So kann z.B. die elektronische Schaltung eine Testfunktion zum Testen des Abschaltens der Stromversorgungseinheit 150 aufweisen, wobei während des Betriebs einer elektrischen Last 130 der erste Steuereingang 154 zum Abschalten der Stromversorgungseinheit 150 für eine kurze Zeit angesteuert wird und der Zustand mindestens einen Ausgangs 115 der elektronischen Schaltungseinheit 110 ausgelesen wird, wobei beim Auslesen die Entladeschaltung 120' für diesen mindestens einen Ausgang 115 eingeschaltet wird. Entspricht der Zustand eines des mindestens einen ausgelesen Ausgangs 115 nicht dem ersten Zustand, dann kann die Stromversorgungseinheit 110 über den zweiten Steuereingang 159, der als zweiter Abschaltweg betrachtet werden kann, komplett abgeschaltet werden. Somit kann während des Betriebs die Abschaltfunktion über den ersten Abschalteingang 154 und dem Schaltelement 153 überwacht werden.

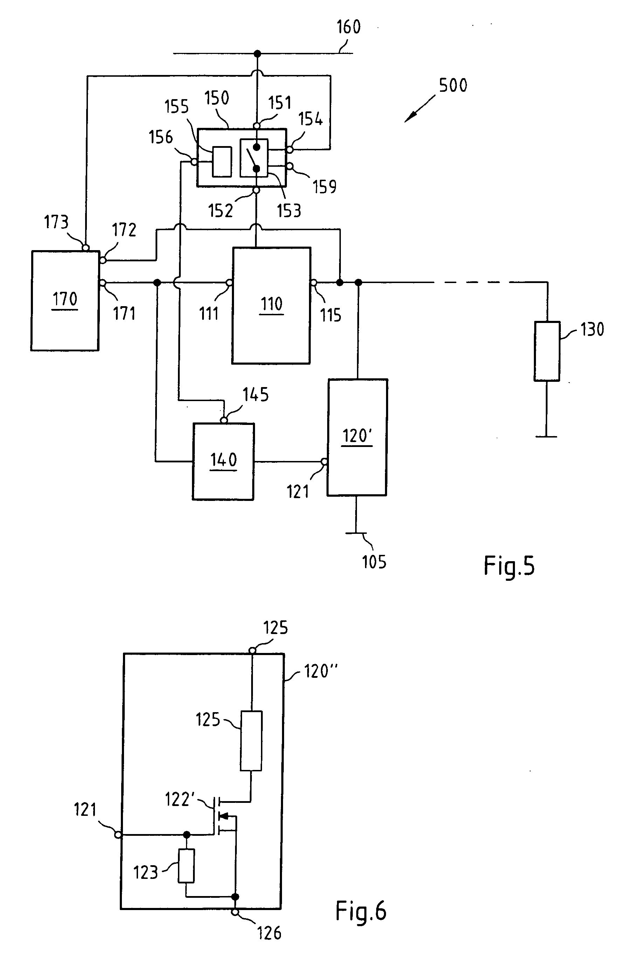

Fig. 5 zeigt eine schematische Darstellung einer fünften beispielhaften Ausführungsform der vorliegenden Erfindung.

Diese fünfte beispielhafte Ausführungsform der elektronischen Schaltung 500 basiert auf der in Fig. 4 gezeigten und zuvor erläuterten vierten beispielhaften Ausführungsform, so dass die zuvor genannten Erläuterungen und Vorteile gleichermaßen für die fünfte Ausführungsform gelten.

Die elektronische Schaltung 500 umfasst eine weitere Steuereinheit 170, welche mit dem mindestens einen Eingang 111 und dem mindestens einen Ausgang der elektronischen Schaltungseinheit 110 verbunden ist und dazu eingerichtet ist, ein Eingangssignal zur Ansteuerung jeweils eines Ausgangs 115 des mindestens einen Ausgangs 115 an mindestens einen des mindestens einen Eingangs 111 anzulegen, wobei die weitere Steuereinheit 170 das Eingangssignal des jeweiligen Ausgangs 115 zum Betreiben einer angeschlossenen elektrischen Last 130 in den zweiten Zustand ansteuert und während des Betriebs dieser elektrischen Last 130 den jeweiligen Ausgang 115 für eine kurze Zeit in den ersten Zustand ansteuert, wobei die Steuereinheit 170 während dieser kurzen Zeit den Zustand des jeweiligen Ausgangs 115 ausliest.

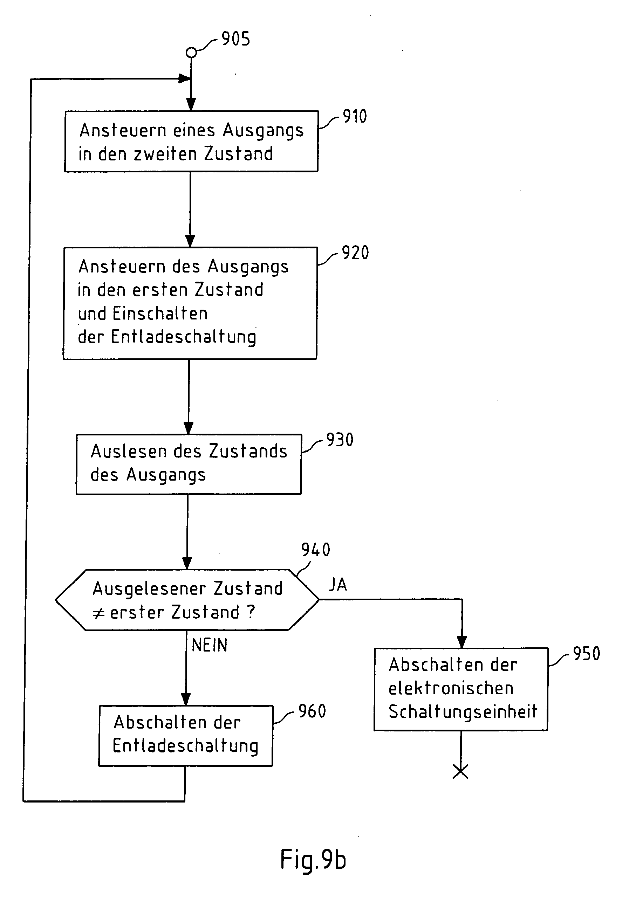

Soll beispielsweise die Zuverlässigkeit des zugeordneten Ausgangs 115 der elektronischen Schaltungseinheit 115 überprüft werden, so kann mit einem entsprechenden Eingangssignal am jeweiligen Eingang des mindestens einen Eingangs 111 der zugeordnete Ausgang 115 kurzzeitig in den ersten Zustand versetzt werden und z.B. gleichzeitig die Entladeschaltung 120' eingeschaltet werden, wie in Schritt 920 im beispielhaften Flussdiagramm der Fig. 9b dargestellt. Durch das Einschalten der Entladeschaltung 120 wird der zugeordnete Ausgang 115 über die Entladeschaltung 120' mit dem Massepotential 105, welches auch ein tieferliegendes Potential darstellen kann, verbunden.

Somit kann beispielsweise direkt bzw. kurz nach dem Schalten in den ersten Zustand und Einschalten der Entladeschaltung 120 an dem zugeordneten Ausgang durch Auslesen des Spannungspegels an diesem Ausgang 115 (Schritt 930 in Fig. 9b) von der weiteren Steuereinheit 170 (Schritt 940 in Fig. 9b) überprüft werden, ob der Ausgang 115 ordnungemäß in den ersten Zustand geschaltet wurde, d.h. ob beispielsweise der Spannungspegel gemäß dem angesteuerten ersten Zustand ordnungsgemäß auf einen sehr niedrigen Spannungspegel oder auf Null abgefallen ist. Die eingeschaltete Entladeschaltung 120 sorgt dafür, wenn die elektrische Last 130 eine kapazitive Last darstellt, dass die kapazitive Last schnell entladen wird, vorausgesetzt, der Ausgang wurde ordnungsgemäß abgeschaltet. Somit wird vermieden, dass die Spannung an diesem Ausgang 115 trotz ordnungsgemäßem Abschalten aufgrund einer kapazitiven Last nur langsam von einem dem zweiten Zustand zugeordneten hohen Spannungspegel abfällt und so ein schnelles Überprüfen des korrekten Abschaltens an diesem Ausgang 115 verhindert wird.

Folglich reicht durch die Verwendung der einschaltbaren Entladeschaltung 120' eine kurze Zeitdauer aus, in der der zu testende Ausgang 115 vom zweiten Zustand in den ersten Zustand angesteuert wird, so dass der Betrieb der jeweiligen elektrischen Last 130 durch diese kurze Testphasen nicht oder nur minimal beeinträchtigt wird.

Tritt während dieser Testphase beim kurzzeitigen Ansteuern einer der Ausgänge 115 in den ersten Zustand ein Fehler der elektronischen Schaltungseinheit 110 auf, d.h. entspricht der ausgelesene Zustand des zu testenden Ausgangs 115 nicht dem erwarteten ersten Zustand (Schritt 940 in Fig. 9b), d.h. bleibt der Spannungspegel an dem jeweiligen Ausgang 115 auf einem entsprechend dem zweiten Zustand hohen Niveau, so fließt zwar ein recht hoher Strom durch die eingeschaltete Entladeschaltung 120, da diese Zeitdauer jedoch sehr kurz gewählt werden kann, z.B. nur eine Millisekunde oder nur wenige Millisekunden, ist dieser hohe Strom für die Entladeschaltung 120 unschädlich. Wird an einem Ausgang ein Fehler festgestellt, so kann die elektronische Schaltungseinheit 110 beispielsweise über einen gesonderten Abschaltweg in einen sicheren Zustand gebracht werden, in dem z.B. die Ausgänge 115 abgeschaltet werden (Schritt 950 in Fig. 9b).

Somit kann mit der vorliegenden Erfindung auch bei elektrischen Lasten 130, welche kapazitive Lasten darstellen, durch gezieltes Zuschalten der ein- und ausschaltbaren Entladeeinheit 120 und Ansteuern eines Ausgangs 115 der elektrischen Schaltungseinheit 110 in den ersten Zustand das sichere Abschalten des entsprechenden Ausgang 115 während des Betriebes schnell und sicher getestet werden.

Ist der zu testende Ausgang 115 fehlerfrei getestet worden, d.h. entspricht der ausgelesene Zustand dem ersten Zustand, so wird die Entladeschaltung 120 wieder abgeschaltet (Schritt 920 in Fig. 9b) und der Ausgang 115 wird zum weiteren Betrieb der elektrische Last 130 wieder in den zweiten Zustand geschaltet (Schritt 910 in Fig. 9b). So kann während des Betriebs einer elektrischen Last 130 der zugeordnete Ausgang 115 durch kurzzeitiges Ansteuern in den ersten Zustand, Einschalten der Entladeschaltung 120 und Auslesen des an diesem Ausgang anliegenden Zustands getestet werden. Dies kann z.B. in zyklischen Abständen erfolgen. Wird ein Fehler detektiert, so kann die elektronische Schaltungseinheit von der weiteren Steuereinheit 170 durch ein Signal am Ausgang 173, welcher z.B. mit dem Schalteingang 154 der Stromversorgungseinheit 150 verbunden ist, abgeschaltet werden.

Auch wenn in Figuren 1-5 exemplarisch nur ein Ausgang 115 der elektronischen Schaltungseinheit 110 dargestellt ist, kann die elektronische Schaltungseinheit 110 mehrere Ausgänge 115 umfassen, wobei z.B. jeder der Ausgänge jeweils eine elektrische Last betrieben kann, und wobei sich jeder der Ausgänge durch ein entsprechendes Eingangssignal in den ersten bzw. den zweiten Zustand ansteuern lässt. Die elektronische Schaltungseinheit 110 kann beispielsweise eine Treiberschaltung mit Halbleiterausgängen 115 darstellen.

Fig. 6 zeigt eine schematische Darstellung einer beispielhaften Entladeschaltung 120" der vorliegenden Erfindung, welche beispielsweise für eine der vorher erläuterten Entladeschaltungen 120 und 120' verwendet werden kann.

Die Entladeschaltung 120" umfasst einen als Schalteinheit wirkenden Transistor 122' und einen Entladewiderstand 125. Über den Eingang 121 und der über Widerstand 123 abfallenden Spannung kann der Transistor 122' gesperrt bzw. durchgesteuert werden, so dass sich die Entladeschaltung 120' über Eingang 121 ein- und ausschalten lässt. Über den Anschluss 125 kann die Entladeschaltung an einen Ausgang des mindestens einen Ausgangs 115 der elektronischen Schaltungseinheit 110 angeschlossen werden, und mit Anschluss 126 kann die Entladeschaltung 120' mit einem Massepotential verbunden werden. Beispielsweise kann für jeden Ausgang der Ausgang 115 der elektronischen Schaltungseinheit 110 eine ein- und ausschaltbare Entladeschaltung 120" verwendet werden.

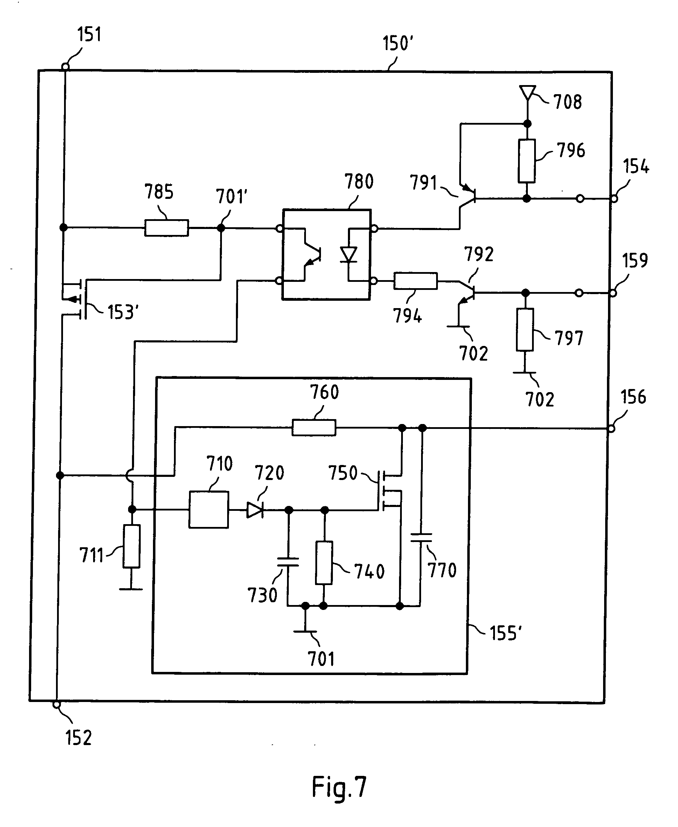

Fig. 7 zeigt eine schematische Darstellung einer beispielhaften Stromversorgungseinheit 150' und Detektionseinheit 155' für die vorliegende Erfindung, welche beispielsweise für die in Fig. 5 eingesetzte Stromversorgungseinheit 150 und Detektionseinheit 155 verwendet werden können.

Über den Anschluss 151 kann die Stromversorgungseinheit 150' beispielsweise an eine stromzuführende Leitung 160 mit einem positiven Versorgungspotential angeschlossen werden. Der Versorgungstransistor 153' dient als Schaltelement, welches über die Steuereingänge 154 und 159 angesteuert und über jeden der beiden Steuereingänge 154 und 159 unabhängig voneinander abgeschaltet werden kann. Somit kann die Versorgungsspannung an den Ausgang 152 gelegt werden, wenn der Transistor 153' durchgesteuert ist. Beispielsweise kann der Versorgungstransistor 153' ein PMOS sein, aber auch ein NMOS mit zusätzlich erzeugter höherer Steuerspannung oder auch ein High-Side-Treiber sein.

Der optionale Optokoppler 780 trennt den Stromkreis der Steuereingänge 154 und 159 galvanisch von dem Versorgungsstromkreis, d.h. der Masse 701 und den Anschlüssen 151 und 152. Die Steuereingangsseite weist eine galvanisch entkoppelte Vorsorgung über das positive Versorgungspotential 708 und die eigene Masse 702 dar. Nur dann, wenn beide Transistoren 791 und 792 durch entsprechende Eingangssignale an den Steuereingängen 154 und 159 durchgeschaltet sind und Widerstand 794 mit dem Versorgungspotential 708 und Masse 702 verbunden ist, verbindet der Optokoppler den Widerstand 711 mit dem Knotenpunkt 701' und der Versorgungstransistor 153' wird durchgeschaltet, wenn an Anschluss 151 die Versorgungsspannung anliegt. Die Widerstände 796 und 797 können beispielsweise zum Sperren der Transistoren dienen, falls die Signale 154, 159 nicht vorhanden sind, wie z.B. beim Reset-Zustand eines Microcontrollers.

Durch den optionalen Optokoppler 780 kann der Signalstromkreis vom Versorgungsstromkreis entkoppelt werden. So kann auch jeder der Eingänge 111 der elektronischen Schaltungseinheit 110 mit jeweils einem Optokoppler (nicht in den Figuren gezeigt) galvanisch vom Versorgungsstromkreis der elektronischen Schaltungseinheit 110 entkoppelt werden, und/oder die Ein- bzw. Ausgänge der Steuereinheiten können durch Optokoppler von dem Versorgungsstromkreis galvanisch getrennt werden.

Die Detektionseinheit 155' ist so ausgelegt, dass am Ausgang 156 das Ausschaltsignal zum Abschalten der Entladeschaltung 120' ausgegeben wird, wenn die an Widerstand 711 detektierte Spannung unter einen vorbestimmten Schwellwert fällt, d.h. wenn z.B. der Versorgungstransistor 153' abgeschaltet wird.

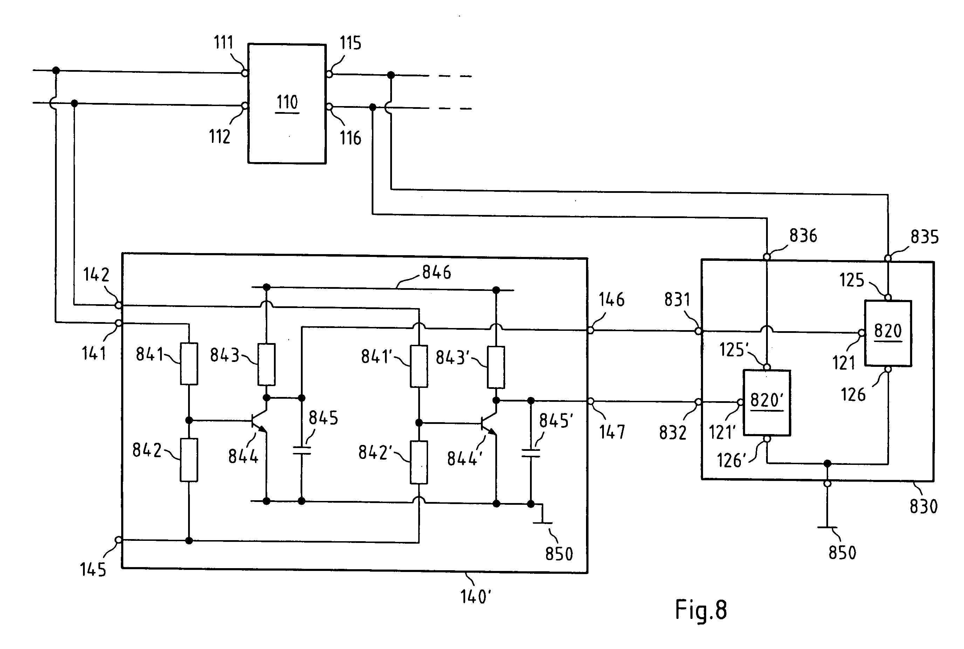

Liegt bei eingeschalteter Stromversorgung ein hohes Potential über dem Widerstand 711 an, so steuert die über Widerstand 740 abfallende Spannung den Transistor 750 durch, so dass der Ausgang 156 auf Masse 701 gezogen wird. Fällt die Spannung über dem Widerstand 711 unter den Schwellwert, z.B. durch Abschalten des Versorgungstransistors 153', so trennt der Transistor 750 den Ausgang 156 von der Masse 701. Dieser Zustand definiert am Ausgang 156 das Ausschaltsignal für die Entladeschaltung 120, wie im Folgenden in Bezug auf Fig. 8 erläutert wird.

Der Kondensator 730 bildet zusammen mit dem Widerstand 740 eine Zeitverzögerungseinheit, so dass der Transistor 750 nicht sofort sperrt, wenn die Spannung über Widerstand 711 unter den Schwellwert fällt. Hierdurch bleibt der Ausgang 156 noch kurzzeitig auf Masse, so dass eine angesteuerte Entladeschaltung 120' während dieser Zeit noch betriebsbereit zum Entladen ist, d.h. einschaltbar ist. Das optionale elektronische Element 710 kann beispielsweise eine weitere Filterschaltung darstellen, und die Diode 720, der Widerstand 760 und der Kondensator 770 können gemäß den Einsatzbedingungen vom Fachmann entsprechend dimensioniert werden.

Fig. 8 zeigt eine schematische Darstellung einer sechsten beispielhaften Ausführungsform der vorliegenden Erfindung.

Diese sechste beispielhafte Ausführungsform der elektronischen Schaltung 600 basiert auf der in Fig. 3 gezeigten und zuvor erläuterten dritten beispielhaften Ausführungsform, so dass die zuvor genannten Erläuterungen und Vorteile gleichermaßen für die sechste Ausführungsform gelten.

Die Steuereinheit 140' kann beispielsweise für jede der zuvor erläuterten Steuereinheiten 140 verwendet werden, wobei der Eingang 145 dazu eingerichtet ist, das Ausschaltsignal zum dauerhaften Ausschalten der Entladeschaltung 830 zu empfangen. Die Entladeschaltung 830 ist über den Anschluss 835 mit dem ersten Ausgang 115 und über den Anschluss 836 mit dem zweiten Ausgang 116 der elektronischen Schaltungseinheit 110 verbunden, so dass diese Ausgänge 115, 116 in Abhängigkeit des an Anschluss 831 bzw. 832 anliegenden Signals gegenüber der Masse 850 entladen werden können.

Die Entladeschaltung 830 umfasst in dieser beispielhaften Ausführungsform eine separate erste Entladeschaltung 820 für den ersten Ausgang 115 und eine separate zweite Entladeschaltung 820' für den zweiten Ausgang 116. Jede der ersten und zweiten Entladeschaltungen 820, 820' kann durch eine der zuvor erläuterten Entladeschaltungen 120,120' realisiert werden.

Die Steuereinheit 140' ist durch die Anschlüsse 141 und 142 jeweils mit dem ersten Eingang 111 und dem zweiten Eingang 112 der elektronischen Schaltungseinheit 110 verbunden, wobei die Steuereinheit 140' dazu eingerichtet ist, in Abhängigkeit eines für die Ansteuerung eines Ausgangs 115,116 angelegten Eingangssignal die diesem Ausgang 115,116 zugeordnete erste Entladeschaltung 820 bzw. zweite Entladeschaltung 820' in den eingeschalteten Zustand anzusteuern, wenn das Eingangssignal den jeweiligen Ausgang 115, 116 in den ersten Zustand ansteuert. Die Anschlüsse 141 und 142 stellen einen ersten Eingang der Steuereinheit 140' dar.

Im Normalzustand, d.h. wenn die Entladeschaltung 830 nicht dauerhaft ausgeschaltet ist bzw. werden soll, wird der zweite Eingang 145 der Steuereinheit 140' auf Masse 850 gelegt. Dies kann z.B. durch den Ausgang 156 der Detektionseinheit 155' in Fig. 7 erfolgen, wobei in diesem beispielhaften Fall die Masse 701 der Masse 850 entspricht. Ferner kann hierbei die Versorgungsleitung 846 mit dem Anschluss 152 der Stromversorgungseinheit 150' verbunden sein.

In diesem Normalzustand steuert die über dem Widerstand 842 abfallende Spannung des die Widerstände 842 und 841 umfassenden Spannungsteilers den Transistor 844, und die über dem Widerstand 842' abfallende Spannung des Spannungsteilers aus Widerständen 842' und 841' den Transistor 844'. Wird beispielsweise der erste Eingang 111 mit einen "LOW"-Signal angesteuert, so dass der entsprechende Ausgang 115 von der elektrischen Schaltungseinheit 110 in den ersten Zustand gesetzt werden soll, so wird die über Widerstand 842 abfallende Spannung sehr klein und der erste Transistor 844 sperrt. Somit liegt am Ausgang 146 eine hohe Spannung an, welche durch die Spannung auf der Versorgungsleitung 846 und den Widerstand 843 definiert wird. Die hohe Spannung stellt ein Signal zum Einschalten der dem ersten Ausgang 115 zugeordneten Entladeschaltung 820 dar, so dass dieser Ausgang 115 gegen Masse 850 entladen wird. Wird der erste Eingang 111 mit einem hohen Pegel angesteuert, so dass der entsprechende Ausgang 115 in den zweiten Zustand zum Betreiben einer elektrischen Last versetzt werden soll, so wird der erste Transistor 844 durchgesteuert und der Ausgang 146 wird auf Masse 850 gezogen, so dass die erste Entladeschaltung 820 abgeschaltet wird.

Gleichermaßen wird durch die Widerstände 842' und 841' der zweite Transistor 844' durch das am zweiten Eingang 112 anliegendem Signal angesteuert, und der Ausgang 147 dementsprechend über die Versorgungsleitung 846 und Widerstand 843' bzw. Masse 850 geschaltet. Die Kondensatoren 845 und 845' bewirken eine Verzögerung des Einschaltsignals für die Entladeschaltung 820, 820', die in etwa der Ausschaltzeit der Schaltungseinheit 110 entspricht.

Über den Eingang 145 kann die Entladeschaltung 850 dauerhaft in den ausgeschalteten Zustand versetzt werden. Das Ausschaltsignal ist hierbei ein von dem Massepotential 850 abweichendes Signal. Wenn an Eingang 145 ein höheres Potential als Masse anliegt, wie beispielsweise 24V über dem Widerstand 760 in Fig. 7, dann werden die Transistoren 844, 844' über die Widerstände 842, 842' dauerhaft angesteuert, wodurch die Entladeschaltungen 820, 820' gesperrt werden.

Somit kann beispielsweise im Normalbetrieb über den ersten Eingang 141, 142 detektiert werden, ob ein Eingangssignal der elektronischen Schaltungseinheit 110 den jeweiligen Ausgang 115, 116 in den ersten Zustand ansteuert, so dass die diesem Ausgang 115, 116 zugeordnete Schalteinheit 820, 820' der Entladeschaltung 830 von der Steuereinheit 140' in den eingeschalteten Zustand angesteuert werden kann, wie zuvor erläutert. Wird jedoch an den zweiten Eingang 145 der Steuereinheit 140' ein Ausschaltsignal angelegt, so führt die Steuereinheit eine Notabschaltung der Entladeschaltung durch, d.h. die mindestens eine Schalteinheit 820, 820' wird dauerhaft in den ausgeschalteten Zustand angesteuert. Wird diese Notabschaltung über den zweiten Eingang 145 ausgelöst, so hat der erste Eingang 141, 142 keinen Einfluss mehr auf die Steuerung der Entladeschaltung 850. Beispielsweise kann somit bei einem detektierten Fehlerfall eine Notabschaltung über den zweiten Eingang 145 der Steuereinheit 140' durchgeführt werden.

Die verschiedenen beschriebenen beispielhaften Ausführungsformen lassen sich nach Belieben miteinander kombinieren.

## Patentansprüche

1. Elektronische Schaltung (100,200), umfassend
eine mindestens einen Eingang (111,112) und mindestens einen Ausgang (115,116) aufweisende elektronische Schaltungseinheit (110) zum Betreiben mindestens einer elektrischen Last (130), wobei die Schaltungseinheit (110) dazu eingerichtet ist, jeweils einen Ausgang (115) des mindestens einen Ausgangs (115,116) in Abhängigkeit eines an einem des mindestens einen Eingangs (111,112) anliegenden Eingangsignals in einen ersten oder einen zweiten Zustand zu schalten, wobei dieser Ausgang (115) im ersten Zustand eine angeschlossene elektrische Last (130) abschaltet und im zweiten Zustand die angeschlossene elektrische Last (130) betreibt, und wobei die elektronische Schaltung (100,200) eine zwischen dem mindestens einen Ausgang (115,116) und einem Massepotential (105,850) angeordnete ein- und ausschaltbare Entladeschaltung (120,120',120",830) umfasst, wobei die elektronische Schaltung (100,200) dazu eingerichtet ist, die Entladeschaltung (120,120',120" ,830) durch ein Ausschaltsignal dauerhaft in den ausgeschalteten Zustand zu schalten, wobei die elektronische Schaltung (100,200) eine ein- und ausschaltbare Stromversorgungseinheit (150,150') für die elektronische Schaltungseinheit (110) und eine Detektionseinheit (155,155') umfasst, und wobei die Detektionseinheit (155,155') dazu eingerichtet ist, einen ausgeschalteten Zustand der Stromversorgungseinheit (150,150') zu detektieren und auf Grundlage des detektierten ausgeschalteten Zustandes das Ausschaltsignal zum dauerhaften Ausschalten der Entladeschaltung auszugeben.

2. Elektronische Schaltung nach Anspruch 1, wobei die Entladeschaltung (120,120',120" ,830) jeweils eine Schalteinheit (122,122') und eine Entladeeinheit (125) für jeweils einen des mindestens einen Ausgangs (115,116) umfasst, und die Schalteinheit (120,120',120",830) dazu eingerichtet ist, in einem eingeschalteten Zustand den jeweiligen Ausgang über die Entladeeinheit (125) mit dem Massepotential (105,850) zu verbinden und in einem ausgeschalteten Zustand vom Massepotential (105,850) zu trennen.

3. Elektronische Schaltung nach Anspruch 2, wobei die Entladeeinheit (125) einen Widerstand umfasst.

4. Elektronische Schaltung nach einem der Ansprüche 2-3, umfassend eine Steuereinheit (140,140'), welche mit mindestens einem des mindestens einen Eingangs (111,112) der elektronischen Schaltungseinheit (110) und mit der Entladeschaltung (120,120',120",830) verbunden ist und dazu eingerichtet ist, in Abhängigkeit eines für die Ansteuerung eines Ausgangs des mindestens einen Ausgangs (115,116) angelegten Eingangssignals die diesem Ausgang zugeordnete Schalteinheit (122,122') der Entladeschaltung (120,120',120'',830) in den eingeschalteten Zustand anzusteuern, wenn das Eingangssignal den jeweiligen Ausgang in den ersten Zustand ansteuert.

5. Elektronische Schaltung nach Anspruch 4, wobei die Steuereinheit (140,140') einen ersten Eingang (141,142) und einen zweiten Eingang (145) umfasst, wobei der erste Eingang (141,142) mit dem mindestens einem Eingang (111,112) der elektronischen Schaltungseinheit (110) verbunden ist, und wobei die Steuereinheit (140,140') dazu eingerichtet ist, eine Notabschaltung der ein- und ausschaltbaren Entladeschaltung (120,120',120'',830) in Reaktion auf ein an den zweiten Eingang angelegtes Ausschaltsignal durchzuführen.

6. Elektronische Schaltung nach Anspruch 1, wobei die Detektionseinheit (155,155') eine Zeitverzögerungseinheit umfasst, so dass das Ausschaltsignal nach Detektion des ausgeschalteten Zustandes der Stromversorgungseinheit (150,150') mit einer Zeitverzögerung ausgegeben wird.

7. Elektronische Schaltung nach einem der Ansprüche 1 und 6, wobei die ein- und ausschaltbare Stromversorgungseinheit (150,150') einen ersten Steuereingang (154) und einen zweiten Steuereingang (159) zum Abschalten der Stromversorgungseinheit (150,150') aufweist, wobei die Stromversorgungseinheit (150,150') dazu eingerichtet ist, über den zweiten Steuereingang (159) unabhängig vom ersten Steuereingang abgeschaltet zu werden, und wobei die elektronische Schaltung eine weitere Steuereinheit umfasst, welche mit dem ersten und zweiten Steuereingang (154,159) und mit mindestens einem Ausgang (115,116) der elektronischen Schaltungseinheit (110) verbunden ist, und wobei die weitere Steuereinheit dazu eingerichtet ist, während des Betriebs einer elektrischen Last (130) den ersten Steuereingang (154) zum Abschalten der Stromversorgungseinheit (150,150') für eine kurze Zeit anzusteuern und den Zustand mindestens einen Ausgangs (115,116) der elektronischen Schaltungseinheit (110) auszulesen.

8. Elektronische Schaltung nach Anspruch 7, wobei die weitere Steuereinheit dazu eingerichtet ist, die Stromversorgungseinheit (150,150') über den zweiten Steuereingang (159) abzuschalten, wenn der ausgelesene Zustand einer des mindestens einen ausgelesenen Ausgangs (115,116) nicht dem ersten Zustand entspricht.

9. Elektronische Schaltung nach einem der Ansprüche 2-8, umfassend eine weitere Steuereinheit (170), welche mit dem mindestens einem Eingang (111,112) und dem mindestens einem Ausgang (115,116) der elektronischen Schaltungseinheit (110) verbunden ist und dazu eingerichtet ist, ein Eingangssignal zur Ansteuerung jeweils eines Ausgangs des mindestens einen Ausgangs (115,116) an mindestens einen des mindestens einen Eingangs (111,112) anzulegen, wobei die weitere Steuereinheit (170) das Eingangssignal des jeweiligen Ausgangs zum Betreiben einer angeschlossenen elektrischen Last (130) in den zweiten Zustand ansteuert und während des Betriebs dieser elektrischen Last (130) den jeweiligen Ausgang für eine kurze Zeit in den ersten Zustand ansteuert, wobei die Steuereinheit (170) während dieser kurzen Zeit den Zustand des jeweiligen Ausgangs ausliest.

10. Elektronische Schaltung nach Anspruch 9, wobei die weitere Steuereinheit (170) dazu eingerichtet ist, die elektronische Schaltungseinheit (110) abzuschalten, wenn der ausgelesene Zustand eines Ausgangs während jener kurzen Zeit nicht dem ersten Zustand entspricht.

11. Verfahren für eine elektronische Schaltung (100,200) mit einer elektronischen Schaltungseinheit (110), wobei die elektronische Schaltungseinheit (100) zum Betrieb mindestens einer elektrischen Last (130) über mindestens einen Ausgang (115,116) eingerichtet ist, und die elektronische Schaltung eine ein- und ausschaltbare Stromversorgungseinheit (150,150') für die elektronische Schaltungseinheit (110) und eine Detektionseinheit (155,155') umfasst, umfassend:
- Schalten von jeweils einem Ausgang des mindestens einen Ausgangs (115,116) in einen ersten oder einen zweiten Zustand in Abhängigkeit eines an einem von mindestens einem Eingang der elektronischen Schaltungseinheit (110) anliegenden Eingangssignals, wobei dieser Ausgang im ersten Zustand eine angeschlossene Last (130) abschaltet und im zweiten Zustand die angeschlossene elektrische Last (130) betreibt,
- Einschalten bzw. Ausschalten einer zwischen dem mindestens einem Ausgang (115,116) und einem Massepotential (105,850) angeordneten Entladeschaltung (120,120',120" ,830),
- Detektieren eines ausgeschalteten Zustands der Stromversorgungseinheit (150,150') durch die Detektionseinheit (155,155'), und
- Ausgeben eines Ausschaltsignals zum dauerhaften Abschalten der Entladeschaltung (120,120',120'',830), wobei die elektronische Schaltung (100,200) dazu eingerichet ist, die Entladeschaltung (120,120',120" ,830) durch das Ausschaltsignal dauerhaft in den ausgeschalteten Zustand zu schalten.
